# EUROPEAN PATENT APPLICATION

(11) **EP 1 852 521 A1**
(43) Date of publication of application: **07.11.2007**
(21) Application number: 07251502.6
(22) Date of filing: 04.04.2007
(51) Int. Cl.: C23C 4/08, C23C 28/00, C23C 30/00, F01D 5/28

(54) **Thermal barrier coatings and processes for applying same**

(30) Priority: 04.04.2006 US 397139
(71) Applicant: United Technologies Corporation, Hartford, CT 06101 (US)
(72) Inventor: Smeggil, John G., Simsbury CT 06070 (US); Chai, Yan, Fremont, CA 94539 (US); Ucasz, Mark T., Middletown, CT 06457 (US)
(74) Representative: Leckey, David Herbert

(57) **Abstract**

A process for applying a coating upon an article (60) includes the steps of applying upon at least one surface (62) of an article (60) a bond coat layer (64) composed of a bond coat material and at least one metal selected from the group consisting of magnesium, calcium, strontium, silicon, rare earth metals, Group 3A of the Periodic Table of Elements and Group 4A of the Periodic Table of Elements; oxidizing the at least one metal to form at least one surface variation on an exposed surface of the bond coat layer and to form a thermally grown oxide layer (68) upon the bond coat layer (64); and applying a thermal barrier coating layer (70) upon said thermally grown oxide layer (68) to produce a coated article.

## Description

### FIELD OF USE

The present invention relates to thermal barrier coatings and, more particularly, to thermal barrier coatings having improved durability.

### BACKGROUND OF THE INVENTION

An exemplary coated metal substrate includes a metallic bond coat layer disposed atop the substrate, a thermally grown oxide (hereinafter "TGO") layer disposed upon the bond coat layer, and a thermal barrier coating (hereinafter "TBC") layer disposed upon the TGO layer. The TGO layer (e.g., alumina) is typically formed after the bond coat layer is deposited, and before the TBC is deposited, by heat treating the bond coated substrate to oxidize the outer surface of the bond coat, thereby creating the TGO layer. Thereafter, the TBC may be deposited upon the TGO layer. In alternative embodiments, the TGO layer may be created as part of the bond coat and/or TBC application processes.

The TGO provides adherence between the TBC layer and the bond coat layer, and also reduces oxygen diffusion from the TBC towards the substrate. During use of the coated metal substrate, this TGO layer typically continues to grow.

TBCs are typically applied by either electron beam-physical vapor deposition processes (hereinafter "EB-PVD") or air plasma spray processes (hereinafter "APS") onto a bond coated metal substrate. In service, the primary mode of failure for TBC-coated hardware involves fracture of the TBC at or near its interface with the TGO, that is, the TBC-TGO interface. In the case of EB-PVD coated hardware, fracture may commonly occur at the TGO-bond coat interface. For APS coated hardware, fracture may commonly occur within the TBC proximate to the TBC-TGO interface.

The cause of failure is generally considered to relate to stresses that arise as a result of a mismatch of coefficients of thermal expansion of materials across the bond coat (or substrate)-TGO-TBC interphase region. Contributing to this mismatch, the properties of the TBC, for example, elastic modulus may change with time due to sintering effects.

As a result, the management of stresses across the bond coat (substrate)-TGO-TBC interface becomes significant. Stresses across the interface are currently addressed by various factors. Principally, the microstructure of the TBC applied by either EB-PVD or APS processes are intended to minimize strain across this interface. The ceramic structure is intended to be compliant for this reason. Sintering inhibits grain-to-grain motion in the ceramic coating during thermal cycling. Consequently, any effect contributing to sintering should be avoided.

Another consideration is that the chemistry of the ceramic may be changed to achieve a better match of coefficients of thermal expansion (hereinafter "CTE") with the substrate. To achieve a better CTE match, potential TBC compositions may be selected based upon their elastic modulus values.

However, prior attempts to improve the durability of TBCs have been directed towards the ceramic materials, where adjustments to the chemistry of the ceramic materials or its applied microstructure have been employed to improve the performance of the overall substrate-TBC system.

Consequently, there exists a need to improve TBCs by modifying the properties of the substrate rather than modifying the ceramic materials of the TBC.

### SUMMARY OF THE INVENTION

In accordance with one aspect of the present invention, a process for applying a coating upon an article broadly comprises applying a bond coat layer upon at least one surface of an article, the bond coat layer broadly comprising a bond coat material and at least one metal selected from the group consisting of magnesium, calcium, strontium, silicon, rare earth metals, Group 3A and Group 4A of the Periodic Table of Elements; oxidizing the at least one metal to form at least one surface variation on an exposed surface of the bond coat layer and to form a thermally grown oxide layer upon the bond coat layer; and applying a thermal barrier coating layer upon said thermally grown oxide layer to produce a coated article.

In accordance with another aspect of the present invention, a bond coat composition broadly comprises a bond coat material and at least one oxidized metal selected from the group consisting of magnesium, calcium, strontium, silicon, rare earth metals, Group 3A of the Periodic Table of Elements and Group 4A of the Periodic Table of Elements.

In accordance with another aspect of the present invention, a coated article broadly comprises a bond coat layer disposed upon at least one surface of the article; a thermally grown oxide layer disposed upon the bond coat layer; and a thermal barrier coating layer disposed upon said thermally grown oxide layer, wherein the bond coat layer broadly comprises a bond coat material and at least one metal selected from the group consisting of magnesium, calcium, strontium, silicon, rare earth metals, Group 3A and Group 4A of the Periodic Table of Elements.

The details of one or more embodiments of the invention are set forth in the accompanying drawings and the description below. Other features and advantages of the invention will be apparent from the description and drawings, and from the claims.

### BRIEF DESCRIPTION OF THE DRAWINGS

FIG. 1 is a flowchart representing a process of the present invention;
FIG. 2A is a flowchart representing one embodiment of a step in the process of FIG. 1;
FIG. 2B is a flowchart representing another embodiment of the step;
FIG. 2C is a flowchart representing yet another embodiment of the step;
FIG. 3 is a representation of a portion of a coated article having an overlay-type bond coat of the present invention; and
FIG. 4 is a representation of a portion of another coated article having a modified pack-type bond coat of the present invention.

Like reference numbers and designations in the various drawings indicate like elements.

### DETAILED DESCRIPTION

Prior attempts to improve the durability of the bond coat have focused upon grade differences in thermomechanical properties across the broad substrate-TBC interphase region by adjusting or modifying properties of the TBC layer. The present invention describes how improved performance can be achieved by altering the microstructure on the bond coat surface immediately adjacent the TGO-TBC interphase region and proximate to the TBC layer.

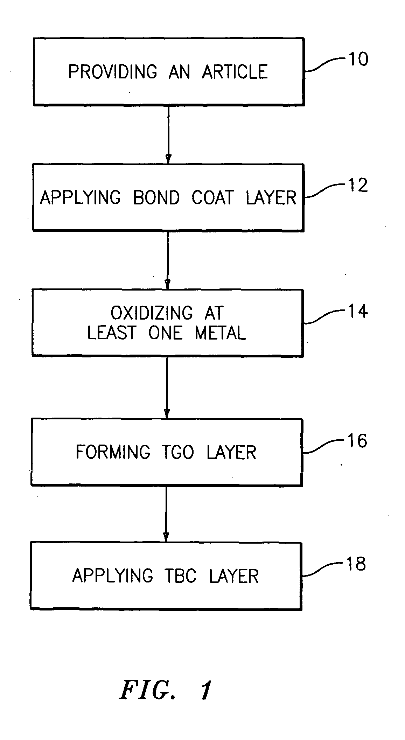

Referring now to FIG. 1, a flowchart representing one of the processes of the present invention is shown. An article may be provided at step 10 and a bond coat layer may be applied at step 12. The bond coat layer may comprise a bond coat material and at least one metal selected from the group consisting of magnesium, calcium, strontium, silicon, rare earth metals, Group 3A of the Periodic Table of Elements and Group 4A of the Periodic Table of Elements.

The bond coat material may comprise a MCrA1Y material. MCrAlY refers to known metal coating systems in which M denotes nickel, cobalt, iron, platinum or mixtures thereof; Cr denotes chromium; Al denotes aluminum; and Y denotes yttrium. MCrAlY materials are often known as overlay coatings because they are applied in a predetermined composition and do not interact significantly with the substrate during the deposition process. For some non-limiting examples of MCrAlY materials see U.S. Pat. No. 3,528,861 which describes a FeCrAlY coating as does U.S. Pat. No. 3,542,530. In addition, U.S. Pat. No. 3,649,225 describes a composite coating in which a layer of chromium is applied to a substrate prior to the deposition of a MCrA1Y coating. U.S. Pat. No. 3,676,085 describes a CoCrAlY overlay coating while U.S. Pat. No. 3,754,903 describes a NiCoCrAlY overlay coating having particularly high ductility. U.S. Pat. No. 4,078,922 describes a cobalt base structural alloy which derives improved oxidation resistance by virtue of the presence of a combination of hafnium and yttrium. A preferred MCrAlY bond coat composition is described in U.S. Pat. No. Re. 32,121, which is assigned to the present Assignee and incorporated herein by reference, as having a weight percent compositional range of about 5-40 Cr, 8-35 Al, 0.1-2.0 Y, 0.1-7 Si, 0.1-2.0 Hf, balance selected from the group consisting of Ni, Co and mixtures thereof. See also U.S. Pat. No. 4,585,481, which is also assigned to the present Assignee and incorporated herein by reference.

The bond coat material may also comprise Al, PtAl and the like, that are often known in the art as diffusion coatings. In addition, the bond coat material may also comprise Al, PtAl, MCrAlY as described above, and the like, that are often known in the art as cathodic arc coatings.

In all of these embodiments, the bond coat material may include at least one noble metal as known to one of ordinary skill in the art.

The particle size for the bond coat material(s) may be of any suitable size and in embodiments may be between about 5 microns (0.005 mm) and about 60 microns (0.060 mm) with a mean particle size of about 25 microns (0.025 mm). The bond coat 30 may be applied to any suitable thickness, and in embodiments may be about 5 mils (0.127 mm) to about 10 mils (0.254 mm) thick. In some embodiments, the thickness may be about 6 mils (0.152 mm) to about 7 mils (0.178 mm) thick.

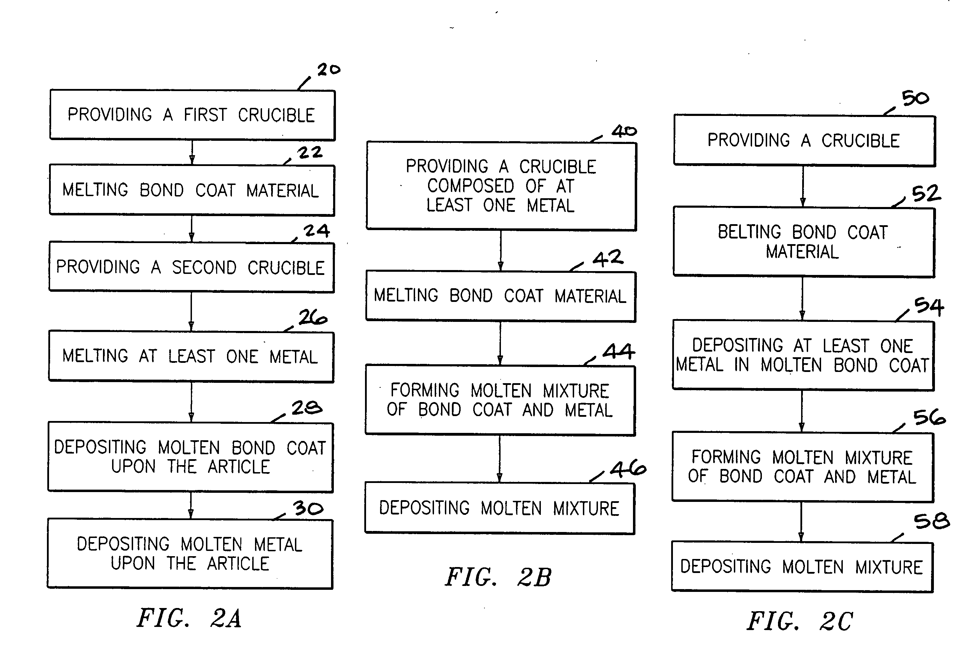

In preparation for the application step 12 of FIG. 1, the bond coat material may be prepared for deposition upon the article using one of any number of methods known to one of ordinary skill in the art. For example, the bond coat material may be melted in a first crucible at steps 20 and 22 to form a molten bond coat material as represented in the flowchart of FIG. 2A. The bond coat material may be melted using any technique known to one of ordinary skill in the art. A second crucible may be provided at step 24 so that the metal(s) may be melted at step 26 to form a molten metal. The metal(s) may be melted using any technique known to one of ordinary skill in the art. The molten bond coat material may then be deposited upon at least one surface of the article at step 28. The molten metal may then be deposited upon an exposed surface of the molten bond coat material at step 30 to form the bond coat layer upon the surface of the article.

In another example, a crucible composed of at least one metal may be provided at step 40 as represented in the flowchart of FIG. 2B. The bond coat material may be melted in the crucible at step 42. As the bond coat material is melted within the crucible, a quantity of metal sufficient to achieve the desired effects of the present invention may break off, flake off, etc. from the crucible and combine with the molten bond coat material to form a molten mixture of bond coat material and the at least one metal at step 44. To achieve this desired result the crucible may be prepped and heated and the bond coat material melted using any technique known to one of ordinary skill in the art. The molten mixture of bond coat material and the at least one metal may then be deposited upon at least one surface of the article at step 46 to form the bond coat layer.

In yet another example, a crucible may be provided at step 50 so that the bond coat material may be melted at step 52 to form a molten bond coat material as represented in the flowchart of FIG. 2C. The bond coat material may be melted using any technique known to one of ordinary skill in the art. As the molten bond coat material remains in the crucible, at least one metal may be added to the molten bond coat material at step 54 to form a molten mixture of bond coat material and metal(s) at step 56. The metal(s) may be melted using any technique known to one of ordinary skill in the art. The molten mixture of bond coat material and metal(s) may then be deposited upon at least one surface of the article at step 58 to form the bond coat layer.

These bond coat material(s) may be applied or deposited by any method capable of producing a dense, uniform, adherent coating of the desired composition, such as, but not limited to, an overlay bond coat, diffusion bond coat, cathodic arc bond coat, etc. Such techniques may include, but are not limited to, diffusion processes (e.g., inward, outward, etc.), low pressure plasma-spray, air plasma-spray, sputtering, cathodic arc, electron beam physical vapor deposition, high velocity plasma spray techniques (e.g., HVOF, HVAF), combustion processes, wire spray techniques, laser beam cladding, electron beam cladding, electroplating, etc.

Referring again to FIG. 1, the at least one metal may be oxidized as represented at step 14. This oxidation may create the surface variations in the bond coat and create the TGO layer upon the bond coat, either simultaneously or in separate process steps. This oxidation may occur during deposition of the bond coat layer, after deposition of the bond coat layer (i.e., via heat treatment), and/or during deposition of the TBC. The metal(s) described herein may be simple oxides that have a strong tendency to react with alumina and form intermediate metal oxide particles. The growth of these oxide particles may be controlled using certain process conditions as known to one of ordinary skill in the art (i.e., oxide formation can be controlled as a function of time, temperature, atmospheric dew point, etc.). Preferably, the oxide particle growth is controlled so that the TGO layer, once formed, exists as a continuous protective layer covering the entire bond coat layer, including the surface variations.

These oxide particles may migrate to the exposed surface of the bond coat layer such that the particles may become oriented substantially horizontal and/or substantially perpendicular to the article's surface. The oxide particles may migrate towards an exposed surface of the bond coat layer to oxidize and continue oxidizing to form a plurality of surface variations. These surface variations may serve to grade the mechanical properties of the bond coat layer adjacent the TGO-TBC interphase region and proximate to the TBC layer. In effect, the oxide particles provide a bond coat layer possessing a more compliant, lower elastic modulus upon which the TBC layer may later be deposited. The oxide particles exhibit and demonstrate beneficial oxide scale adherence effects as recognized and known to one of ordinary skill in the art.

Referring back to the flowchart of FIG. 2B, the following example demonstrates the beneficial oxide scale adherence effects being sought. The bond coat material may be melted in a crucible composed of magnesium oxide-stabilized zirconia. First, both magnesium and zirconium may react with a quantity of sulfur found in the bond coat material, which reduces the sulfur content of the resultant bond coat layer and promotes good oxide scale adherence of the TGO in subsequent oxidation. Secondly, the additional yttrium and zirconium appear to be present in the bond coat material in a form that is potentially mobile, that is, as a low melting eutectic as opposed to a refractory sulfide particle as is understood by one of ordinary skill in the art.

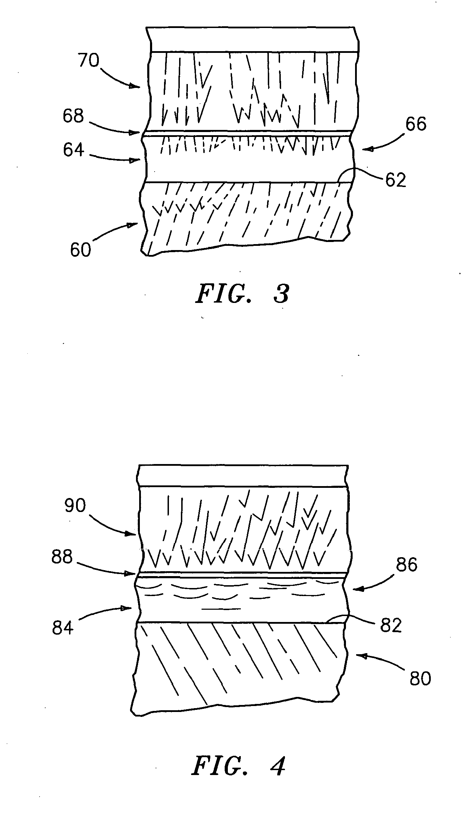

Referring now to FIG.-3, when applying the bond coat layer 64 by, for example, cathodic arc processing, the impacting particles provide enough energy to locally heat the immediately adjacent areas of the article 60 being coated. If there is sufficient heat, low melting phases will dissolve and be continually drawn to the surface of the bond coat layer 64 as the coating layer grows in thickness. Once at the surface of the bond coat layer 64, the metal(s) particles may preferentially oxidize to produce the oxidized particles 66 and the resulting surface variations. When employing a cathodic arc process, it has been observed that the resulting surface variations, that is, the oxidized particles 66 appear largely perpendicular to the surface 62 of the article 60 as shown in FIG. 3.

Although the example involves a cathodic arc process, the process of the present invention may be modified to utilize other processes described herein. For example, a PtAl bond coat layer may be applied using a pack aluminization process as known to one of ordinary skill in the art. The at least one metal may be applied using a physical vapor deposition (PVD) process as is known to one of ordinary skill in the art. Referring now to FIG. 4, the deposited films 84, 90 may comprise the metal(s) that in turn, after being oxidized, form extensive oxidation deposits 86 in the processed bond coat layer. When employing a PVD process, it has been observed that the resulting surface variations, that is, the oxidized particles 86 appear largely horizontal to the surface 82 of the article 80 as shown in FIG. 4.

The at least one metal in the bond coat layer may be oxidized, either while the bond coat layer is applied, after the bond coat layer is applied, and/or while the TBC is applied. In embodiments such as shown in FIG. 2A, the at least one metal may be oxidized under a low vacuum while depositing the metal(s) at a pressure of about 0.010 torr to 0.020 torr.

As another alternative to the processes of FIGS. 2A, 2B and 2C, at least one metal may also be introduced as fine oxide particles after applying a bond coat layer via a thermal spray process. In another alternative embodiment, the at least one metal may comprise fine organic resin particulates that may be burned off to create the desired surface variations in the exposed surface of the bond coat layer. In yet another alternative embodiment, the at least one metal may comprise electrically conductive fine oxide particles which may be electroplated upon the bond coat layer.

Referring again to FIG. 1, as shown at step 16, the TGO layer may be formed on the bond coat layer, either while the surface variations are being created or after. The TGO may be formed during application of the bond coat layer, after application of the bond coat layer (i.e., via heat treating), and/or during application of the TBC layer, as known to one of ordinary skill in the art. For example, the alumina based layer, that is, the TGO layer, may be formed upon the bond coat layer, before the TBC is applied, by being heat treated at about 1500°F to about 2100°F (~816°C to ~1149°C) for about 5 minutes to about 4 hours. Preferably, the TGO layer may be formed as a continuous protective layer upon the bond coat layer, including the surface variations.

Optionally, the article may be coated with a thermal barrier compound to form a TBC layer at step 18 once the TGO layer is formed. The TBC may comprise a ceramic based compound for use with turbomachinery applications as known to one of ordinary skill in the art. Representative thermal barrier compounds include, but are not limited to, any stabilized zirconate, any stabilized hafnate, combinations comprising at least one of the foregoing compounds, and the like, for example, yttria stabilized zirconia, calcia stabilized zirconia, magnesia stabilized zirconia, yttria stabilized hafnia, calcia stabilized hafnia and magnesia stabilized hafnia. Yttria stabilized zirconia is commercially available as 7YSZ^{®}.

The thermal barrier compound may be applied to the article using any number of processes known to one of ordinary skill in the art. Suitable application processes include, but are not limited to, physical vapor deposition (e.g., electron beam), thermal spray (e.g., air plasma, high velocity oxygen fuel), sputtering, sol gel, slurry, combinations comprising at least one of the foregoing application processes, and the like. After applying the TBC layer, the resultant coated article may be heat treated at about 1250°F to about 2100°F (~6.77°C to ~1149°C) for about 5 minutes to about 4 hours .

The article may comprise a part used in turbomachinery applications such as, but not limited to, any part having an airfoil, any part having a seal, airfoils, seals, and the like. As known to one of ordinary skill in the art, TBC coatings for turbomachinery parts having seals, or seals in general, are typically thicker than TBC coatings for turbomachinery parts having an airfoil, or airfoils in general. Likewise, the TBC coatings of the present invention adhere to these industry standards as known to one of ordinary skill in the art. For example, the article may include, but is not limited to blades, vanes, stators and mid-turbine frames. And, in yet another example, the article may include, but is not limited to, seals, combustor panels, combustor chambers, combustor bulkhead panels, disk side plates and fuel nozzle guides.

Referring now to FIG. 3, an article 60 may have at least one surface 62. A bond coat layer 64 having a plurality of oxidized particle 66 may be disposed upon the surface 62. A TGO layer 68 may be disposed upon the bond coat layer 66 and proximate to the oxidized particles 66. A TBC layer 70 may be disposed upon the TGO 68. The bond coat layer 64 may be an overlay-type bond coat with oxidized particles being oriented substantially perpendicular to the article's surface.

Referring now to FIG. 4, an article 80 may have at least one surface 82. A bond coat layer 84 having a plurality of oxidized particles 86 may be disposed upon the surface 82. A TGO layer 88 may be disposed upon the bond coat layer 84 and proximate to the oxidized particles 86. A TBC layer 90 may be disposed upon the TGO 88. The bond coat layer may be a pack-type bond coat with oxidized particles being oriented substantially horizontal to the article's surface.

It is to be understood that the invention is not limited to the illustrations described and shown herein, which are deemed to be merely illustrative of the best modes of carrying out the invention, and which are susceptible to modification of form, size, arrangement of parts, and details of operation. The invention rather is intended to encompass all such modifications which are within its scope as defined by the claims.

## Claims

1. A process for applying a coating upon an article (60; 80), comprising:
applying upon at least one surface of an article a bond coat layer (64; 84) comprising a bond coat material and at least one metal selected from the group consisting of magnesium, calcium, strontium, silicon, rare earth metals, Group 3A and Group 4A of the Periodic Table of Elements; oxidizing said at least one metal to form at least one surface variation on an exposed surface of said bond coat layer and to form a thermally grown oxide layer (68; 88) upon said bond coat layer (64; 84); and
applying a thermal barrier coating layer (70; 90) upon said thermally grown oxide layer (68; 88) to produce a coated article.

2. The process of claim 1, wherein the oxidation step comprises oxidizing said at least one metal to form a plurality of oxidized particulate metal (86) proximate to an exposed surface of said bond coat layer and oriented substantially horizontal to said at least one surface (82) of said article (80).

3. The process of claim 1, wherein the oxidation step comprises oxidizing said at least one metal to form a plurality of oxidized particulate metal (66) proximate to an exposed surface of said bond coat layer and oriented substantially perpendicular to said at least one surface (62) of said article (60).

4. The process of any preceding claim, wherein the oxidation step comprises oxidizing said at least one metal at a pressure of about 0.010 to 0.020 torr.

5. The process of any preceding claim, wherein the oxidation step comprises heat treating the bond coated article at about 1500°F to 2150°F (~816°C to ~1149°C) for about 5 minutes to 4 hours to form an alumina based layer upon said bond coat layer before the thermal barrier coating is applied.

6. The process of any preceding claim, wherein the step of applying said bond coat layer comprises utilizing a deposition process selected from the group consisting of diffusion processes, low pressure plasma-spray, air plasma-spray, sputtering, cathodic arc, electron beam physical vapor deposition, high velocity plasma spray techniques, combustion processes, wire spray techniques, laser beam cladding, electron beam cladding, and electroplating.

7. The process of any preceding claim, wherein the step of applying said bond coat layer comprises the steps of:
melting said bond coat material in a first crucible;
melting said at least one metal in a second crucible;
applying said bond coat material upon said at least one surface of said article; and
applying said at least one metal upon an exposed surface of said bond coat material.

8. The process of claim 7, wherein the at least one metal is applied at a pressure of about 0.010 torr to 0.020 torr.

9. The process of any of claims 1 to 6, wherein the step of applying said bond coat layer comprises the steps of:
melting said bond coat material in a crucible comprising at least one metal;
forming a molten mixture of said bond coat material and said at least one metal; and
depositing said molten mixture upon said at least one surface to form said bond coat layer.

10. The process of any of claims 1 to 6, wherein the step of applying said bond coat layer comprises the steps of:
melting said bond coat material in a crucible to form molten bond coat material;
depositing said at least one metal into said molten bond coat material;
forming a molten mixture of said bond coat material and said at least one metal; and
depositing said molten mixture upon said at least one surface to form said bond coat layer.

11. The process of any preceding claim, wherein the step of applying the thermal barrier coating comprises utilizing a deposition process selected from group consisting of physical vapor deposition processes, thermal spray processes, sputtering processes, sol gel processes, and slurry processes.

12. A bond coat composition, comprising:
a bond coat material and at least one oxidized metal selected from the group consisting of magnesium, calcium, strontium, silicon, rare earth metals, Group 3A and Group 4A of the Periodic Table of Elements.

13. The bond coat composition of claim 12, wherein said bond coat material comprises an optional noble metal and an MCrAlY material, wherein said M is a metal selected from the group consisting of nickel, cobalt, iron and mixtures thereof.

14. The bond coat composition of claim 12 or 13, wherein said bond coat material comprises an optional noble metal and a material selected from the group consisting of aluminum, platinum, and mixtures thereof.

15. The bond coat composition of claim 12, wherein said bond coat material comprises an optional noble metal and a material selected from the group consisting of aluminum, platinum and MCrAlY, wherein said M of said MCrAlY is a metal selected from the group consisting of nickel, cobalt, iron, and mixtures thereof.

16. A coated article, comprising:
a bond coat layer (64; 84) disposed upon at least one surface (62; 82) of said article (60; 80);
a thermally grown oxide layer (68; 88) disposed upon said bond coat layer (64; 84); and
a thermal barrier coating layer (70; 90) disposed upon said thermally grown oxide layer (68; 88),
wherein said bond coat layer (64; 84) comprises a bond coat material and at least one metal selected from the group consisting of magnesium, calcium, strontium, silicon, rare earth metals, Group 3A and Group 4A of the Periodic Table of Elements.

17. The coated article of claim 16, wherein said at least one metal comprises a plurality of oxidized particulate metal (86) oriented substantially horizontal to said at least one surface (82).

18. The coated article of claim 16, wherein said at least one metal comprises a plurality of oxidized particulate metal (66) oriented substantially perpendicular to said at least one surface (62).

19. The coated article of claim 16, 17 or 18, wherein said bond coat material comprises an optional noble metal and a material selected from the group consisting of aluminum, platinum and MCrAlY, wherein said M of said MCrAlY is a metal selected from the group consisting of nickel, cobalt, iron, and mixtures thereof.

20. The coated article of any of claims 16 to 19, wherein said thermal barrier coating comprises at least one of:
a stabilized zirconate; and
a stabilized hafnate.

21. The coated article of any of claims 16 to 20, wherein said article (60; 80) comprises a turbine engine component.
